# EUROPEAN PATENT APPLICATION

(11) **EP 2 476 554 A1**
(43) Date of publication of application: **18.07.2012**
(21) Application number: 11193905.4
(22) Date of filing: 16.12.2011
(51) Int. Cl.: B41J 2/16

(54) **Manufacturing method of inkjet head**

(30) Priority: 17.01.2011 JP 2011007127
(71) Applicant: Toshiba TEC Kabushiki Kaisha, Tokyo 141-8664 (JP)
(72) Inventor: Shimosato, Masashi, Shinagawa-ku, Tokyo 141-8664 (JP)
(74) Representative: Gendron, Vincent Christian

(57) **Abstract**

A manufacturing method of an inkjet head which ejects ink due to deformation of a Pb free piezoelectric member which is caused by applying a driving voltage. In the method, an electrode which is used when applying the driving voltage is formed by forming a first conductive pattern in the Pb free piezoelectric member, forming an insulating layer in a region other than a region where at least the first conductive pattern is formed, in the Pb free piezoelectric member, and forming a second conductive pattern on the first conductive pattern using electroplating.

## Description

### CROSS-REFERENCE TO RELATED APPLICATION(S)

This application is based upon and claims the benefit of priority from Japanese Patent Application No, 2011-007127, filed on January 17, 2011; the entire contents of which are incorporated herein by reference.

### FIELD

Embodiments described herein relate generally to a manufacturing method of an inkjet head.

### BACKGROUND

In an inkjet head, ink is ejected by deforming a piezoelectric member along with the application of a voltage. In the piezoelectric member, electrodes for applying the voltage to the piezoelectric member are formed. It is possible to form the electrode in the piezoelectric member using electroplating.

As a material for forming the piezoelectric member, there is a material in which lead is used, or a material in which lead is not used. Generally, the piezoelectric member in which lead is not used has a smaller specific resistance than the piezoelectric member in which lead is used. When forming the electrode in the piezoelectric member in which lead is not used using electroplating, there is concern that plating may be precipitated due to a flow of a weak current in a region where the electrode is not formed in the piezoelectric member.

### DESCRIPTION OF THE DRAWINGS

Fig. 1 is a cross-sectional view of an inkjet head according to a first embodiment.
Fig. 2 is a cross-sectional view of the inkjet head according to the first embodiment.
Fig, 3 is an explanatory diagram which describes an operation of the inkjet head according to the first embodiment.
Fig. 4 is the explanatory diagram which describes the operation of the inkjet head according to the first embodiment.
Fig. 5 is a diagram which shows a manufacturing process of the inkjet head according to the first embodiment.
Fig. 6 is a diagram which shows the manufacturing process of the inkjet head according to the first embodiment.
Fig. 7 is a diagram which shows the manufacturing process of the inkjet head according to the first embodiment.
Fig. 8 is a diagram which shows the manufacturing process of the inkjet head according to the first embodiment.
Fig. 9 is a diagram which shows the manufacturing process of the inkjet head according to the first embodiment.
Fig. 10 is a schematic diagram of an ink supply unit.
Fig. 11 is a diagram which shows the appearance of an inkjet head according to a second embodiment.
Fig. 12 is a cross-sectional view of the inkjet head according to the second embodiment.
Fig. 13 is a diagram which shows a manufacturing process of the inkjet head according to the second embodiment.
Fig. 14 is a diagram which shows the manufacturing process of the inkjet head according to the second embodiment.
Fig. 15 is a diagram which shows the manufacturing process of the inkjet head according to the second embodiment.
Fig. 16 is a diagram which shows the manufacturing process of the inkjet head according to the second embodiment.
Fig. 17 is a diagram which shows the appearance of an inkjet head according to a third embodiment.
Fig. 18 is a cross-sectional view of the inkjet head according to the third embodiment.
Fig. 19 is a diagram which shows a configuration of a driving unit of a piezoelectric member according to the third embodiment.
Fig. 20 is a diagram which shows a forming process of the driving unit of the piezoelectric member according to the third embodiment.
Fig. 21 is a diagram which shows a forming process of the driving unit of the piezoelectric member according to the third embodiment.
Fig. 22 is a diagram which shows a forming process of the driving unit of the piezoelectric member according to the third embodiment.
Fig. 23 is a diagram which shows a forming process of the driving unit of the piezoelectric member according to the third embodiment.

### DETAILED DESCRIPTION

In the embodiment, there is provided a manufacturing method of an inkjet head which ejects ink due to deformation of a Pb free piezoelectric member which occurs along with the application of a driving voltage. In the method, an electrode which is used in the application of the driving voltage is formed by forming a first conductive pattern in the Pb free piezoelectric member, an insulating layer at least in a region of the Pb free piezoelectric member other than the region where the first conductive pattern is formed, and a second conductive pattern on the first conductive pattern using electroplating.

Preferably, the first conductive pattern is formed on the insulating layer, after forming the insulating layer.

Preferably still, the insulating layer is a compact layer compared to the Pb free piezoelectric member.

Preferably yet, the first conductive pattern is formed using electroless plating.

It is preferable that the Pb free piezoelectric member is formed of niobate-based dielectric material.

Preferably, the insulating layer is formed using a glass coating agent.

The present invention further relates to a method of forming an electrode for applying a voltage to Pb free piezoelectric member in the Pb free piezoelectric member comprising: forming a first conductive pattern in the Pb free piezoelectric member; forming an insulating layer in a region other than a region where at least the first conductive pattern is formed among the Pb free piezoelectric member; and forming the electrode by forming a second conductive pattern on the first conductive pattern using electroplating.

The above, and the other objects, features and advantages of the present invention will be made apparent from the description of preferred embodiments, given as non-limiting examples. Hereinafter, embodiments of the invention will be described with reference to the drawings.

### (First embodiment)

An inkjet head according to a first embodiment will be described.

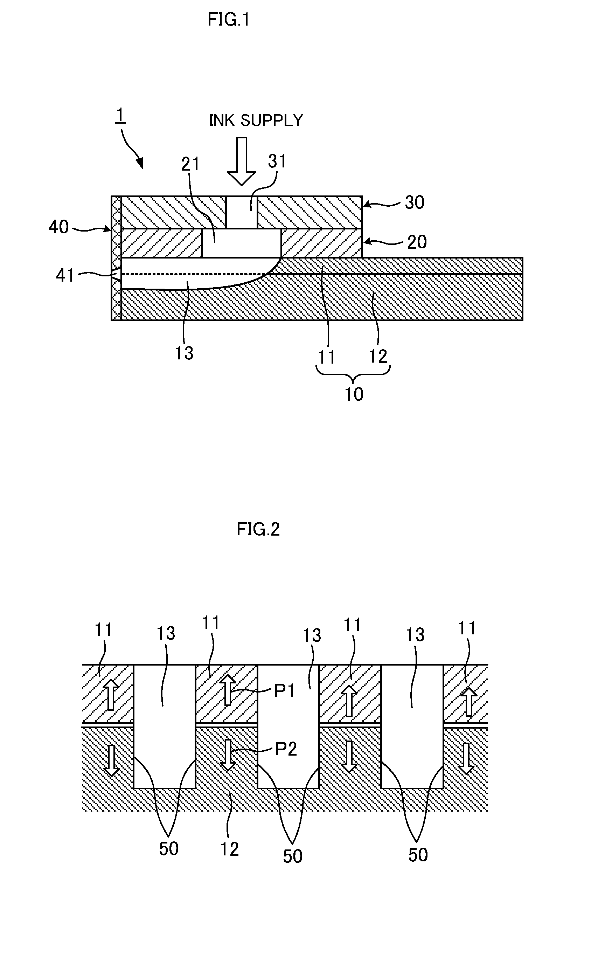

The structure of an inkjet head 1 will be described with reference to Figs. 1 and 2. Fig. 1 is a cross-sectional view of the inkjet head. Fig. 2 is a cross-sectional view of the inkjet head in a surface which is orthogonal to a sheet surface of Fig. 1.

The inkjet head 1 includes a substrate 10. The substrate 10 is configured by laminating two piezoelectric members 11 and 12. As the material of the piezoelectric member 11, it is possible to use a material which does not include lead, and more specifically, a niobate-based dielectric material. As the niobate-based dielectric material, for example, there are sodium niobate, potassium niobate, and potassium sodium niobate. As a material of the piezoelectric member 12, it is possible to use the same material as that of the piezoelectric member 11, or a different material from that of the piezoelectric member 11.

The two piezoelectric members 11 and 12 are subject to polarization treatment. As shown in Fig. 2, the polarization directions P1 and P2 of the two piezoelectric members 11 and 12 are different from each other. The direction of arrow P1 is the polarization direction of the piezoelectric members 11, and the direction of arrow P2 is the polarization direction of the piezoelectric members 12. The piezoelectric members 11 and 12 which constitute a pressure chamber 13 are covered with electrodes 50.

The substrate 10 has pressure chambers 13. As shown in Fig. 2, a plurality of pressure chambers 13 is aligned in one direction. The pressure chamber 13 is configured by the piezoelectric members 11 and 12, and the piezoelectric members 11 and 12 which constitute the pressure chamber 13 correspond to a driving unit.

Electrodes are formed on the inner wall surface of the pressure chamber 13. The electrodes are used to apply a voltage to the piezoelectric members 11 and 12 which constitute the pressure chamber 13. The electrodes which are formed on the inner wall surface of the pressure chamber 13 are connected to a driving circuit through the electrodes which are formed on the surface of the substrate 10. The driving circuit applies the voltage with respect to the piezoelectric members 11 and 12 using a predetermined driving pattern.

A frame member 20 is provided on the surface of the substrate 10, and clogs a part of the pressure chamber 13. The frame member 20 has an opening portion 21, and the opening portion 21 is connected to the pressure chamber 13.

A lid member 30 is fixed to the frame member 20. The lid member 30 has an opening portion 31, and the opening portion 31 is connected to the opening portion 21 of the frame member 20. The opening portions 21 and 31 are passages for guiding ink to the pressure chamber 13. The opening portion 31 is connected to an ink tank through a tube.

A nozzle plate 40 is fixed to an end surface of the substrate 10, and clogs the pressure chamber 13. The nozzle plate 40 is also fixed to the frame member 20 and the lid member 30. The nozzle plate 40 has a nozzle 41, and the nozzle 41 is connected to the pressure chamber 13. The nozzle 41 is provided corresponding to each of the pressure chambers 13.

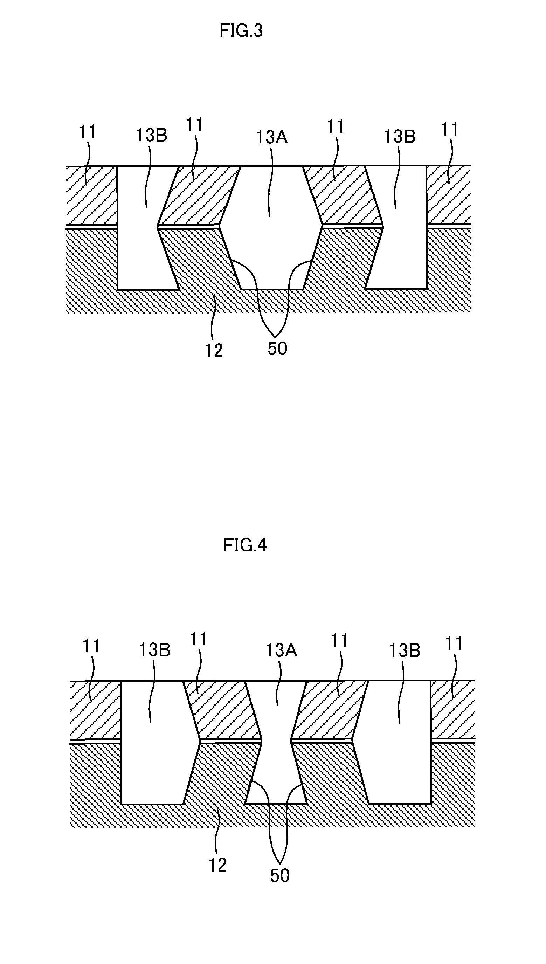

Subsequently, an operation of the inkjet head 1 will be described with reference to Figs. 3 and 4. When a voltage is applied to the piezoelectric members 11 and 12 which constitute the pressure chamber 13 from the electrodes 50, as shown in Figs. 3 and 4, it is possible to deform the piezoelectric members 11 and 12.

In a state shown in Fig. 3, a capacity of a pressure chamber 13A increases by deformation of the piezoelectric members 11 and 12. It is possible to take in the ink in the pressure chamber 13A, by increasing the capacity of the pressure chamber 13A. That is, the ink moves to the pressure chamber 13A passing through the opening portions 31 and 21. In a pressure chamber 13B neighboring the pressure chamber 13A, the capacity thereof is reduced due to the deformation of the piezoelectric members 11 and 12.

In a state shown in Fig. 4, the capacity of the pressure chamber 13A is reduced due to the deformation of the piezoelectric members 11 and 12. By reducing the capacity of the pressure chamber 13A, and by increasing the internal pressure of the pressure chamber 13A, it is possible to allow the ink to eject, which is taken in the pressure chamber 13A. The ink in the pressure chamber 13A is ejected to the outside of the inkjet head 1 passing through the nozzle 41. In the pressure chamber 13B neighboring the pressure chamber 13A, the capacity thereof is increased due to the deformation of the piezoelectric members 11 and 12.

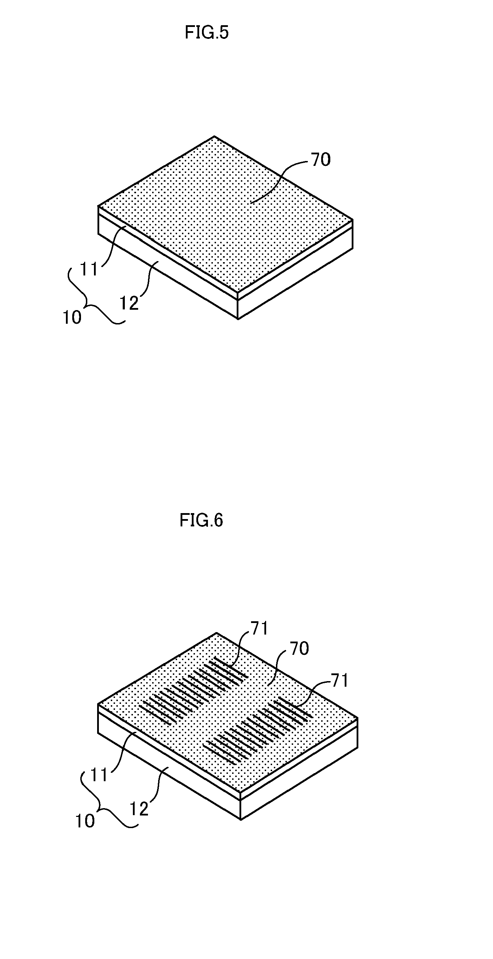

Subsequently, the manufacturing method of the inkjet head 1 will be described with reference to Figs. 5 to 9.

First, as shown in Fig. 5, the substrate 10 is formed by laminating the piezoelectric members 11 and 12 which are tabular shapes. As described using Fig. 2, the piezoelectric members 11 and 12 are polarized in the directions of arrows P1 and P2. A glass coating layer (insulating layer) 70 is formed on the front surface of the substrate 10. The glass coating layer 70 is formed on the front surface of the piezoelectric member 11, and is formed on the entire front surface of the substrate 10, according to the embodiment. As a glass coating agent which forms the glass coating layer 70, for example, Siragusital, which is manufactured by Bokuto Kasei Kogyo KK, may be used.

It is possible to form the glass coating layer 70 on the substrate 10 using a well-known method. In detail, it is possible to form the glass coating layer 70 using a dry coating method or a wet coating method. If a temperature is too high when forming the glass coating layer 70, then there is concern that the substrate 10 (piezoelectric members 11 and 12) may deteriorate, therefore it is preferable to form the glass coating layer 70 taking into consideration this fact. For example, as a temperature when forming the glass coating layer 70, it is possible to set the temperature to a half or less of Curie temperature of the substrate 10 (piezoelectric members 11 and 12).

Subsequently, as shown in Fig. 6, a plurality of grooves 71 is formed on the substrate 10 on which the glass coating layer 70 is formed. The groove 71 corresponds to the pressure chamber 13. It is possible to form the groove 71, for example, using a diamond-cutter. The formation position or the number of the groove 71 is appropriately set in consideration of a structure or the like of the inkjet head 1. In the embodiment, the plurality of grooves 71 is formed through alignment in one direction, and two rows of the plural grooves 71 are provided.

Subsequently, a resist is applied to the entire front surface of the glass coating layer 70, and exposing and developing are performed so that the resist remains only in regions where the electrodes are not formed. In addition, a plating nucleus is formed with respect to regions where the electrodes are formed, by performing a preprocessing of the plating. When separating the resist, the plating nucleus remains only in the region where the electrodes are formed.

In the embodiment, the resist is applied after forming the groove 71, however, it is possible to apply the resist before forming the groove 71. In detail, the exposing and developing are performed so that the resist remains only in the region where the electrodes are not formed after applying the resist in the entire front surface of the glass coating layer 70. In addition, it is possible to form the groove 71 at a predetermined position of the region where the electrodes are formed.

When a liquid resist is used, it is preferable to form the groove 71 after applying the resist. When the liquid resist is applied after forming the groove 71, the liquid resist is filled in the groove 71, and it is difficult to remove the resist. When applying the resist after forming the groove 71, it is preferable to use a dry film resist or an electrodeposition resist. It is possible to prevent the resist from filling into the groove 71 by using the dry film resist or the electrodeposition resist.

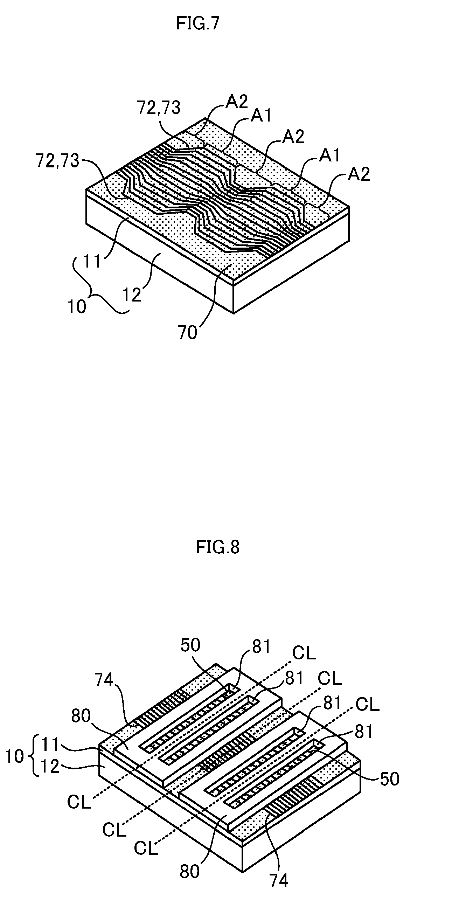

Subsequently, a first conductive pattern 72 of nickel is formed in the region where the plating nucleus is present by performing electroless Ni plating (refer to Fig. 7). A region A1 of the first conductive pattern 72 is formed in the groove 71, and comes into contact with the piezoelectric members 11 and 12. The region A1 of the first conductive pattern 72 corresponds to the electrode 50 which is described in Fig. 3. A region A2 of the first conductive pattern 72 is formed in a predetermined region other than the groove 71, and on the front surface of the glass coating layer 70. That is, the glass coating layer 70 is present between the first conductive pattern 72 (region A2) and the piezoelectric members 11.

Subsequently, a second conductive pattern (gold plating) 73 is formed on the surface of the first conductive pattern 72 using the electroplating. In this manner, electrodes 50 and 74 for applying the driving voltage to the piezoelectric members 11 and 12 are formed on the front surface of the substrate 10. The electrodes 50 and 74 have a configuration where the first conductive pattern 72 and the second conductive pattern 73 are laminated. The electrode 50 is an electrode of a part which corresponds to the region A1 shown in Fig. 7, and the electrode 74 is an electrode of a part which corresponds to the region A2 shown in Fig. 7.

It is possible to suppress the deviation of resistance values of the electrodes 50 and 74 by reducing the resistance values of the electrodes 50 and 74, when forming the second conductive pattern (gold plating) 73. In addition, it is possible to use the gold plating in order to suppress the formation of the oxide film. If a part of the first conductive pattern 72 is connected to the second conductive pattern, it becomes easy to perform the electroplating. The part to which the first conductive pattern 72 is connected may be removed, after performing the electroplating.

Subsequently, as shown in Fig. 8, two frame members 80 are disposed at the upper surface of the electrodes 50 and 74. Each frame member 80 is arranged along a row of the grooves 71 (electrode 50). The frame member 80 has two opening portions 81, and there is a row of the grooves 71 (electrode 50) in the inner side of each of the opening portions 81. The frame member 80 corresponds to the frame member 20 described in Fig. 1, and the opening portion 81 corresponds to the opening portion 21 of the frame member 20.

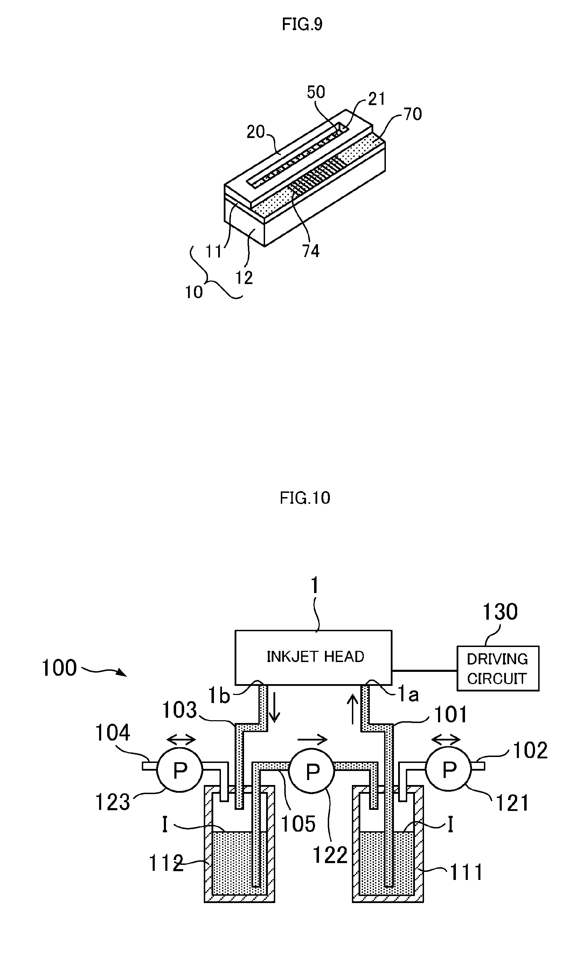

When cutting the member shown in Fig. 8 along three cutting lines CL, it is possible to obtain a structure body shown in Fig. 9. In Fig. 9, if the lid member 30 is fixed to the frame member 20, then the inkjet head 1 described in Fig. 1 is obtained. As shown in Fig. 9, if ink is supplied to the opening portion 21 of the frame member 20, then it is possible to supply ink to the plurality of grooves 71 (pressure chamber 13) which is positioned inside the opening portion 21.

According to the embodiment, the region other than the first conductive pattern 72 is covered with the glass coating layer 70, when forming the second conductive pattern 73 on the first conductive pattern 72 using electroplating. It is possible to prevent the plating from being precipitated in the region other than the first conductive pattern 72, by performing the electroplating when the piezoelectric member 11 is covered with the glass coating layer 70. Particularly, it is meaningful in preventing the plating from being precipitated, when the first conductive pattern 72 is compactly formed.

The piezoelectric member 11 is formed of a material which does not include lead, and has a small specific resistance compared to the piezoelectric member which is formed of PZT. Here, if the second conductive pattern 73 is to be formed using electroplating without forming the glass coating layer 70, in a state where the piezoelectric member 11 is exposed, there is concern that a weak current flows in the region where the first conductive pattern 72 is not formed, and the plating is precipitated. In the embodiment, since the region other than the first conductive pattern 72 is covered with the glass coating layer 70 (insulating layer) , it is possible to prevent the weak current from flowing in the region other than the first conductive pattern 72, and to suppress the precipitation of the plating.

In addition, it is possible to prevent the preprocessing solution of electroless plating from permeating between particles of the piezoelectric member 11, by covering the front surface of the piezoelectric member 11 with the glass coating layer 70, before forming the first conductive pattern 72 by using electroless plating. It is possible to form the electrode 74 only in a predetermined region, by preventing the preprocessing solution from permeating between particles of the piezoelectric member 11. Since the glass coating layer 70 is a compact substance compared to the piezoelectric member 11, it is possible to prevent the plating from bleeding out.

According to the embodiment, a glass coating agent is used as the material of the glass coating layer 70, however, it is possible to use another material. As the material of the glass coating layer 70, for example, it is possible to use an organic material such as polyimide (PI). When forming the second conductive pattern 73 using electroplating, it is preferable that the material of the glass coating layer 70 have insulation properties, in order to prevent the plating from being precipitated in regions other than the first conductive pattern 72. When forming the first conductive pattern 72 using electroless plating, it is preferable that the glass coating layer 70 be more compact than the piezoelectric member 11, in order to prevent the permeation of the preprocessing solution, and to prevent the plating from bleeding out.

When considering the manufacturing process of the inkjet head 1, it is preferable that the glass coating layer 70 can endure processing other than the electroless plating (for example, etching) . In addition, when the inkjet head 1 is used, it is preferable that the glass coating layer 70 can endure the ink, since it comes into contact with the ink.

In the embodiment, the glass coating layer 70 is formed on the entire front surface of the substrate 10, however, it is possible to form the glass coating layer 70 in only a part of region of the substrate 10. In detail, it is possible to form the glass coating layer 70 at least in a region where the electrode 74 forms.

The method of forming the electrodes 50 and 74 is not limited to the method which is described in the embodiment. The electrode 50 may be formed on the surface of the groove 71, and the electrode 74 may be formed in the region other than the groove 71. For example, in a state shown in Fig. 6, electroless plating is performed on the entire surface of the glass coating layer 70. Subsequently, a mask is formed in the region where the electrodes 50 and 74 are formed, and the plating in a region where the electrodes 50 and 74 are not formed can be removed using the etching.

According to the embodiment, the glass coating layer 70 is formed before forming the first conductive pattern 72 using the elecroless plating, however, it is possible to form the glass coating layer 70 in a region other than the first conductive pattern 72 after forming the first conductive pattern 72. If the glass coating layer 70 is formed in the region other than the first conductive pattern 72, after forming the first conductive pattern 72, it is possible to prevent the plating from being precipitated in the region other than the first conductive pattern 72 when forming the second conductive pattern 73 by using electroplating.

### (Second embodiment)

An inkjet head according to a second embodiment will be described.

An ink supply unit 100 which supplies ink to an inkjet head 1 according to the embodiment will be described with reference to Fig. 10.

A first ink tank 111 is connected to an ink supply port 1a of the inkjet head 1 through a tube 101. Ink I is received in the first ink tank 111, and the ink I in the first ink tank 111 is supplied to the ink supply port 1a through the tube 101, by an operation (pressure adjustment) of a first pump 121.

The first pump 121 is connected to the first ink tank 111 through a tube 102. Air pressure in the first ink tank 111 is adjusted using the first pump 121, and is maintained in a state of being higher than atmospheric pressure. It is possible to supply the ink I in the first ink tank 111 to the inkjet head 1 through the tube 101. An arrow which is attached to the first pump 121 denotes the movement direction of air due to an operation of the first pump 121.

A second ink tank 112 is connected to an ink outlet 1b of the inkjet head 1 through a tube 103, and the ink discharged from the ink outlet 1b is received in the second ink tank 112. The ink I in the second ink tank 112 passes through a tube 105 and is guided to the first ink tank 111 due to an operation of a conveying pump 122. The ink I circulates passages of the first ink tank 111, inkjet head 1, and the second ink tank 112. An arrow which is attached to the conveying pump 122 shows the movement direction of the ink I along with the operation of the conveying pump 122.

A second pump 123 is connected to the second ink tank 112 through a tube 104. The second pump 123 is adjusted so that air pressure in the second ink tank 112 is maintained to a state which is lower than atmospheric pressure. An arrow which is attached to the second pump 123 shows the movement direction of air due to an operation (pressure adjustment) of the second pump 123.

A driving circuit 130 sends a driving signal to the inkjet head 1. The inkjet head 1 ejects ink when receiving the driving signal from the driving circuit 130.

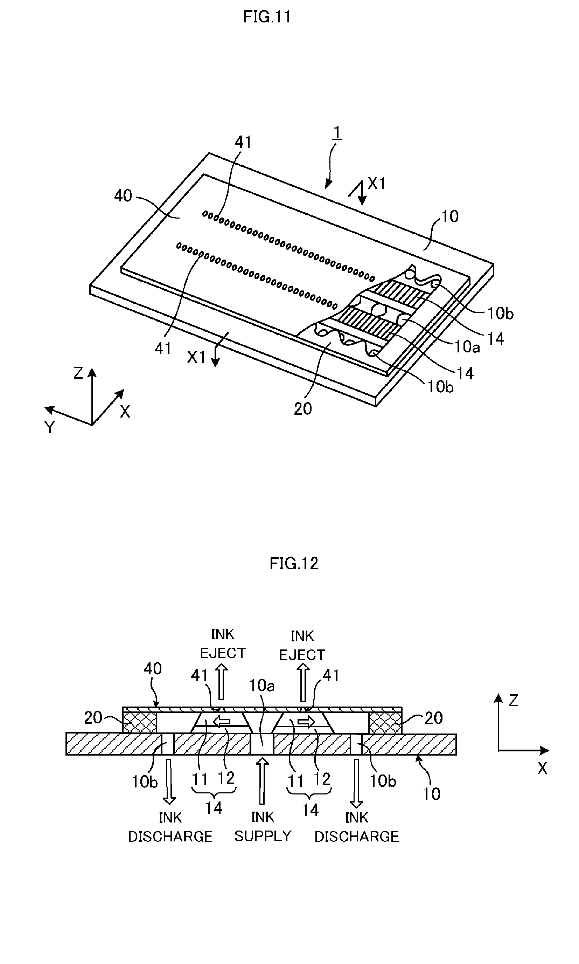

Subsequently, a structure of the inkjet head according to the embodiment will be described. Fig. 11 is a diagram which shows the appearance of the inkjet head according to the embodiment. Fig. 12 is a cross-sectional diagram of Fig. 11 which is taken along line X1-X1. In Figs. 11 and 12, the X, Y, and Z axes are orthogonal to each other.

A driving unit 14 is provided on the upper surface of a substrate 10. The driving unit 14 is formed by laminating two piezoelectric members 11 and 12. For example, the substrate 10 can be formed of Alumina or niobate-based dielectric material. The piezoelectric members 11 and 12 can be formed of, for example, the niobate-based dielectric material. Similarly to the first embodiment, the piezoelectric members 11 and 12 are polarized in directions opposite to each other.

As shown in Fig. 11, a plurality of driving units 14 are aligned in the Y direction, and there are two rows of the plurality of driving units 14. A pressure chamber is present between the two rows of the plurality of driving units 14 which are neighboring each other in the Y direction, and it is possible to change the capacity of the pressure chamber by deforming the two driving units 14. An operation of the driving unit 14 is the same as the operation described in Figs. 3 and 4.

Electrodes are formed on the wall surface of the driving unit 14 which constitutes the pressure chamber. If a voltage is applied to the driving unit 14 through the electrodes, it is possible to deform the driving unit 14. If the capacity of the pressure chamber is increased due to the deformation of the driving unit 14, it is possible to draw ink into the pressure chamber. If the capacity of the pressure chamber is reduced due to the deformation of the driving unit 14, it is possible to eject the ink.

The substrate 10 has a supply port 10a and an outlet 10b. The supply port 10a is present between the two driving units 14 which are neighboring each other in the X direction. The outlet 10b is present on the opposite side of the supply port 10a side with respect to the driving unit 14. A frame member 20 is arranged at the upper surface of the substrate 10, and the frame member 20 surrounds the plurality of driving units 14. A nozzle plate 40 is fixed to the upper surface of the driving units 14 and the frame member 20.

The nozzle plate 40 has a plurality of nozzles 41, and each nozzle 41 is provided corresponding to the pressure chamber. As shown in Fig. 11, the plurality of nozzles 41 is aligned in the Y direction, and two rows of the plurality of nozzles 41 are provided. According to the embodiment, two rows of the plurality of nozzles 41 are provided which align in the Y direction, however, one row of the plurality of nozzles 41 which align in the Y direction may be provided. The number of the nozzles 41 is appropriately set.

Subsequently, an operation of the inkjet head according to the embodiment will be described. An arrow shown in Fig. 12 denotes the movement direction of the ink.

The ink moves to the inside of the inkjet head 1 from the supply port 10a. The ink which passed through the supply port 10a proceeds to both sides in the X direction with respect to the supply port 10a. The ink from the supply port 10a moves to the pressure chamber. If the driving unit 14 deforms when ink is in the pressure chamber, the ink in the pressure chamber passes through the nozzles 41, and can be ejected to the outside of the inkjet head 1. The ink which has passed through the pressure chamber moves toward the outlet 10b of the substrate 10.

When the ink moves toward the outlet 10b from the supply port 10a, it is possible to discharge bubbles to the outside of the inkjet head 1 using the movement of the ink, even when the bubbles are generated inside the inkjet head 1. In addition, it is possible to suppress the change in temperature of the ink in the inkjet head 1, when the ink continuously moves toward the outlet 10b from the supply port 10a.

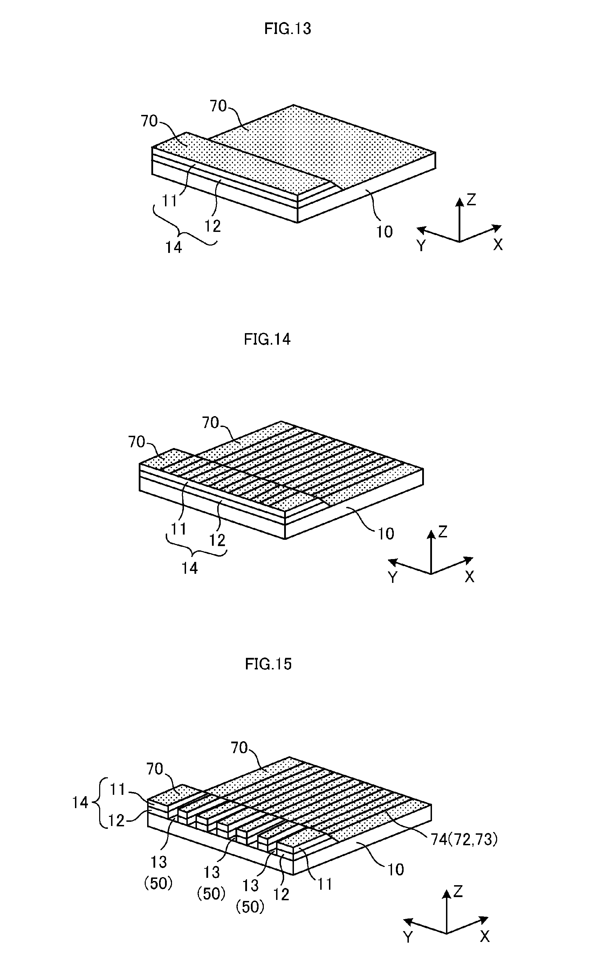

Subsequently, the manufacturing method of the inkjet head 1 will be described with reference to Figs. 13 to 16.

As shown in Fig. 13, the driving unit 14 is formed on the front surface of the substrate 10. For example, it is possible to process the driving unit 14 to a shape shown in Fig. 13, after the two piezoelectric members 11 and 12 are laminated. Similarly to the first embodiment, the glass coating layer 70 is formed with respect to the front surface of the substrate 10 and the driving unit 14. The glass coating layer 70 is a compact layer compared to the piezoelectric member 11 and the substrate 10.

According to the embodiment, the glass coating layer 70 is formed on the entire front surface of the substrate 10 and the driving unit 14. Even in the embodiment, as a material for the glass coating layer 70, it is possible to use a material other than the glass coating agent, for example, an organic material such as polyimide (PI).

It is preferable to use a dry coating method when forming the glass coating layer 70. When forming the glass coating layer 70 using a wet coating method, a coating agent is easily filled in the base end portion of the driving unit 14.

Subsequently, the resist is applied to the entire front surface of the glass coating layer 70, and exposing and developing are performed so that the resist remains only in the region where the electrodes 50 and 74 are not formed.

Subsequently, the groove (pressure chamber) 13 is formed with respect to the driving unit 14 shown in Fig. 14. As shown in Fig. 15, the plurality of driving units 14 which is aligned in the Y direction is formed by forming the plurality of grooves 13. In addition, the first conductive pattern 72 is formed using electroless plating with respect to the region where the resist is not formed and the groove 13.

Subsequently, it is possible to form the electrodes 50 and 74, by forming the second conductive pattern 73 on the first conductive pattern 72 using electroplating. The electrodes 50 and 74 have a configuration where the first conductive pattern 72 and the second conductive pattern 73 are laminated. The electrode 50 is an electrode which is formed along the wall surface of the groove 13, and comes into contact with the driving unit 14. The electrode 74 is formed on a region other than the groove 13, and the glass coating layer 70 is present between the electrode 74 and the substrate 10.

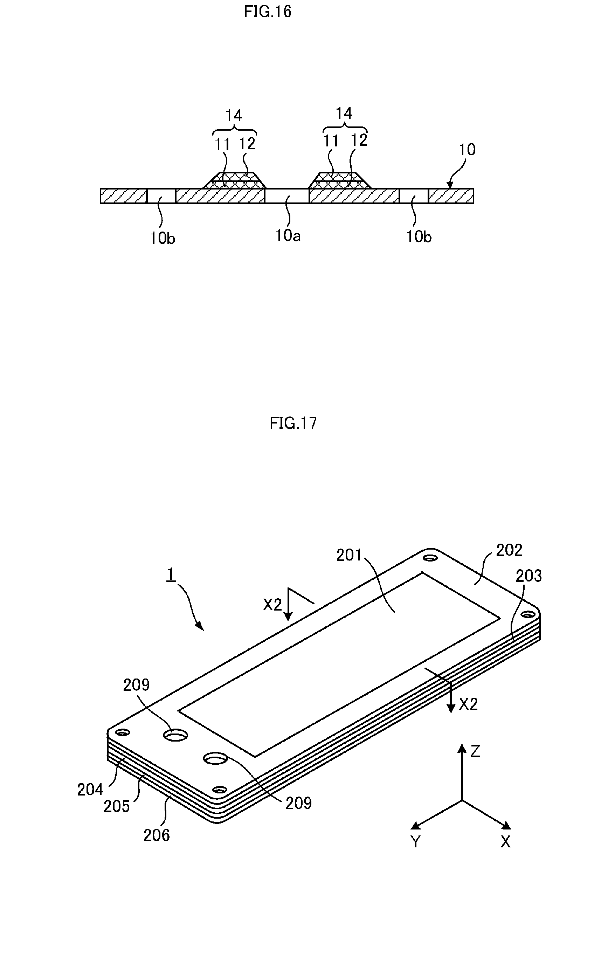

As shown in Fig. 16, by preparing two structure bodies which are shown in Fig. 15, it is possible to constitute a part of the inkjet head 1. The outlet 10b is formed in the substrate 10.

According to the embodiment, it is also possible to prevent the plating from being precipitated in the region other than the first conductive pattern 72 when performing the electroplating, since the region other than the first conductive pattern 72 is covered with the glass coating layer 70 when forming the second conductive pattern 73 using electroplating.

In addition, it is possible to prevent the preprocessing solution of plating from permeating between the substrate 10 and the particles of the driving unit 14, by forming the glass coating layer 70 on the substrate 10 or the front surface of the driving unit 14 before forming the first conductive pattern 72.

### (Third embodiment)

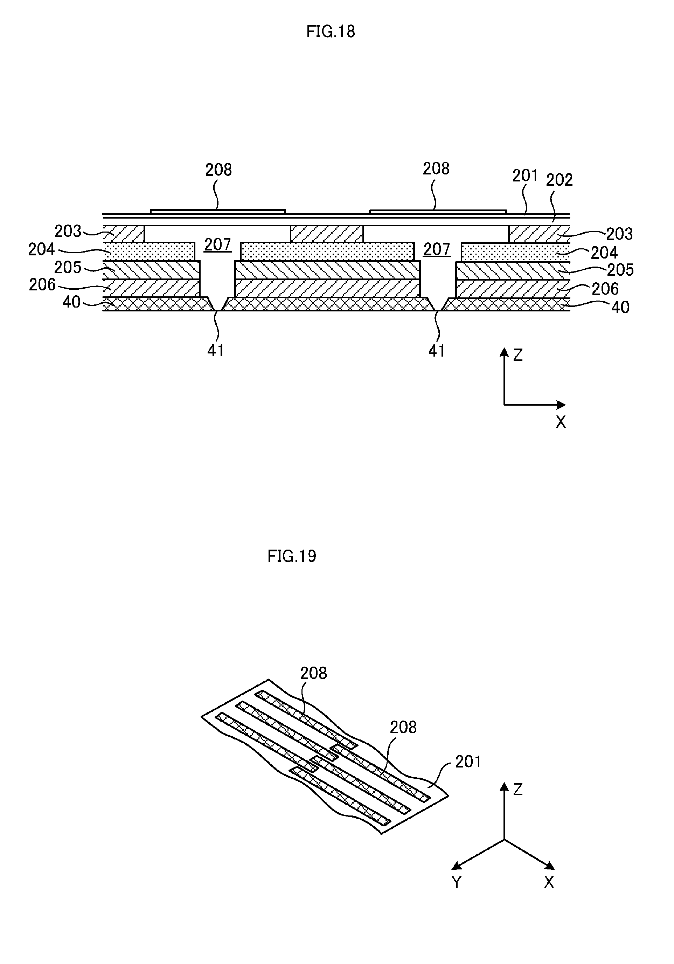

An inkjet head according to a third embodiment will be described. Fig. 17 is a diagram which shows the appearance of the inkjet head according to the embodiment. Fig. 18 is a cross-sectional view of Fig. 17 taken along line X2-X2. In Fig. 17, the X, Y, and Z axes are orthogonal to each other. The relationship among the X, Y, and Z axes is similar in Figs. 18 to 23.

The inkjet head 1 has a laminated structure, and a piezoelectric member 201, a vibration plate 202, a cavity plate 203, a spacer plate 204, manifold plates 205 and 206, and a nozzle plate 40 are overlapped from the uppermost layer toward the lower layer. The nozzle plate 40 has a plurality of nozzles 41. The vibration plate 202 has a supply port 209 which takes in the ink.

In the spacer plate 204 and the manifold plates 205 and 206, an opening portion which corresponds to the nozzle 41 is formed. A liquid chamber 207 is configured by these opening portions. The ink in the liquid chamber 207 is guided to the nozzle 41.

The piezoelectric member 201 is formed as a film on the vibration plate 202, and is subjected to polarization treatment. In the embodiment, the polarization direction is orthogonal with respect to the surface of the vibration plate 202. An electrode 208 which corresponds to each of the liquid chambers 207 is formed on the upper surface (the surface opposite to the vibration plate 202) of the piezoelectric member 201. As shown in Fig. 19, the electrode 208 is extended in the X direction, the vibration plate 202 is formed of a conductive metal, and the piezoelectric member 201 is interposed between the vibration plate 202 and the electrode 208.

A wiring is connected to the plurality of electrodes 208, and a voltage from the driving unit is applied thereto. When the voltage is applied to the electrode 208, an electric field is formed in the same direction as the polarization direction. The electrode 208 is a positive electrode, and the vibration plate 202 is an earth electrode. The piezoelectric member 201 (corresponding to driving unit), which is positioned immediately below the electrode 208 to which a voltage is applied, is driven, and contracts in a direction orthogonal to the polarization direction. Since the vibration plate 202 does not contract, the vibration plate 202 and the piezoelectric member 201 deform so as to be convex on the liquid chamber 207 side.

When the vibration plate 202 and the piezoelectric member 201 deform so as to be convex on the liquid chamber 207 side, the capacity in the liquid chamber 207 decreases, and the internal pressure of the liquid chamber 207 increases. When the internal pressure of the liquid chamber 207 increases, the ink in the liquid chamber 207 is ejected from the nozzle 41. When applying of the voltage to the electrode 208 is stopped, the piezoelectric member 201 and the vibration plate 202 return to a flat board shape from a curved shape, and the capacity of the liquid chamber 207 returns to its original capacity. Since the liquid chamber 207 is in a decompressed state, the ink is taken into the liquid chamber 207.

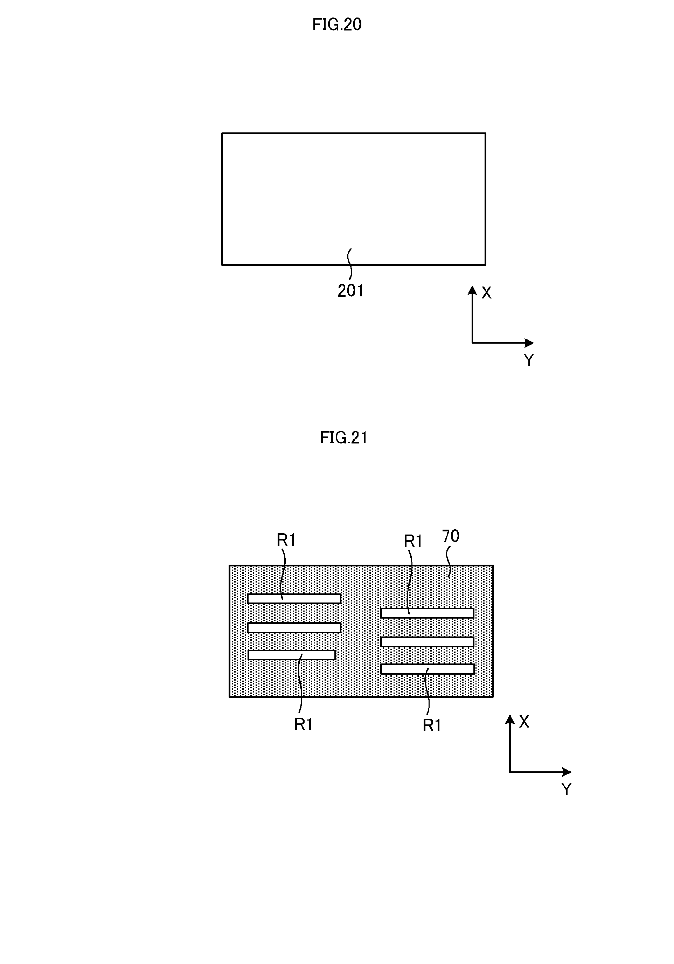

Subsequently, a method of forming the electrode 208 in the piezoelectric member 201 will be described with reference to Figs. 20 to 23. Figs. 20 to 23 are diagrams of the piezoelectric member 201 which are seen in the same direction.

First, the piezoelectric member 201 of a flat board shape shown in Fig. 20 is prepared. The glass coating layer 70 is formed on the front surface of the piezoelectric member 201 as shown in Fig. 21. The glass coating layer 70 is a compact layer compared to the piezoelectric member 201.

As shown in Fig. 21, the glass coating layer 70 is not formed at a region R1 which is a part of the piezoelectric member 201 forming the electrode 208. The region R1 is a region which corresponds to a part of the electrode 208. For example, it is possible to apply a glass coating agent on the front surface of the piezoelectric member 201, in a state where the region R1 is masked. It is possible to form the glass coating layer 70 shown in Fig. 21, when a mask is peeled off after applying the glass coating agent.

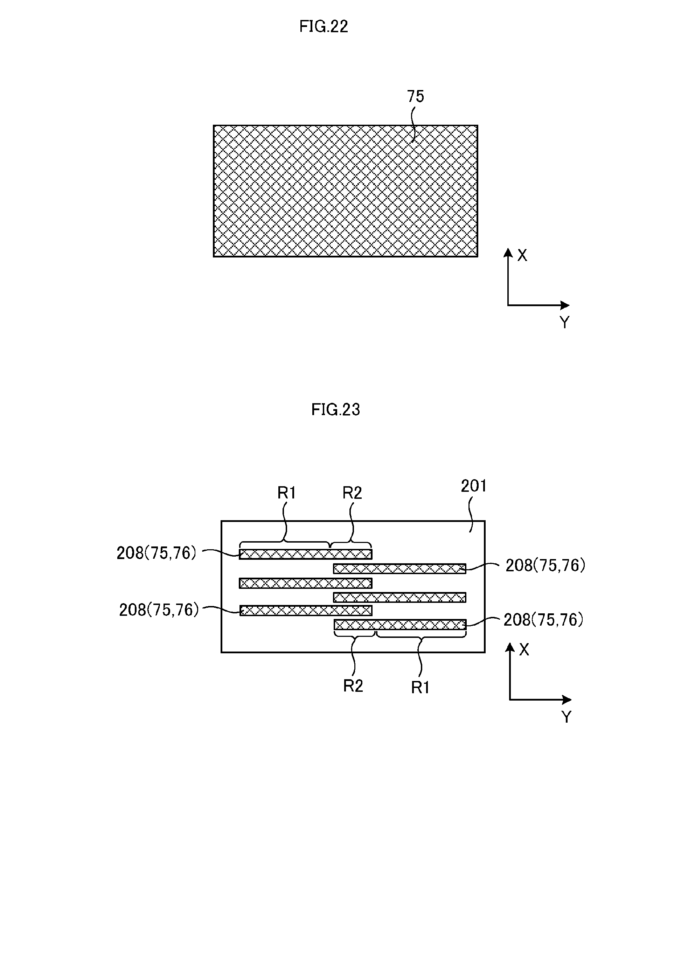

Subsequently, as shown in Fig. 22, a first conductive layer 75 is formed using electroless plating, with respect to a surface on which the glass coating layer 70 is formed. The conductive layer 75 is formed by nickel plating. The first conductive layer 75 is formed with respect to the entire surface of the piezoelectric member 201.

Subsequently, in the first conductive layer 75, a region other than the region where the electrode 208 is formed is removed using etching. The region where the electrode 208 is formed is regions R1 and R2. In the region R1, the first conductive layer 75 comes into contact with the piezoelectric member 201. In the region R2, the glass coating layer 70 is present between the first conductive layer 75 and the piezoelectric member 201.

Further, a second conductive layer 76 is formed on a surface of the first conductive layer 75 using electroplating. In the embodiment, the second conductive layer 76 is formed by gold plating. The electrode 208 has a structure in which the first conductive layer 75 and the second conductive layer 76 are laminated.

According to the embodiment, when the second conductive layer 76 is formed by electroplating, since the glass coating layer 70 covers the region other than the first conductive layer 75, it is possible to prevent the plating from precipitating in the region other than the first conductive layer 75 due to the electroplating.

According to the embodiment, the glass coating layer 70 is provided between the first conductive layer 75 and the piezoelectric member 201, in the region R2. It is possible to prevent the plating from bleeding out even if electroless plating is performed, by providing the glass coating layer 70. Particularly, since the regions R2 are formed at positions close to each other, it is possible to prevent the plating from bleeding out between two regions R2 which are close to each other, by forming the glass coating layer 70 with respect to the region R2.

In the above described embodiment, the manufacturing method of the inkjet head 1 was described, however, the embodiments may be applied to manufacturing methods other than that of the inkjet head 1. That is, it is possible to apply the embodiments when forming the electrode in the piezoelectric member using electroless plating.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A manufacturing method of an inkjet head which ejects ink due to deformation of a Pb free piezoelectric member which is caused by an application of a driving voltage comprising:
forming a first conductive pattern in the Pb free piezoelectric member;
forming an insulating layer in a region other than a region where the first conductive pattern is formed, among the Pb free piezoelectric member; and
forming an electrode which is used for applying the driving voltage, by forming a second conductive pattern on the first conductive pattern using electroplating.

2. The method according to claim 1,
wherein the first conductive pattern is formed on the insulating layer, after forming the insulating layer.

3. The method according to claim 2,
wherein the insulating layer is a compact layer compared to the Pb free piezoelectric member.

4. The method according to any one of claims 1 to 3, wherein the first conductive pattern is formed using electroless plating.

5. The method according to any one of claims 1 to 4, wherein the Pb free piezoelectric member is formed of niobate-based dielectric material.

6. The method according to any one of claims 1 to 5, wherein the insulating layer is formed using a glass coating agent.

7. A method of forming an electrode for applying a voltage to Pb free piezoelectric member in the Pb free piezoelectric member comprising:
forming a first conductive pattern in the Pb free piezoelectric member;
forming an insulating layer in a region other than a region where at least the first conductive pattern is formed among the Pb free piezoelectric member; and
forming the electrode by forming a second conductive pattern on the first conductive pattern using electroplating.
